# EUROPEAN PATENT APPLICATION

(11) **EP 4 036 588 A1**
(43) Date of publication of application: **03.08.2022**
(21) Application number: 21154142.0
(22) Date of filing: 28.01.2021
(51) Int. Cl.: G01R 15/18, G01R 15/20, G01R 33/12

(54) **MONITORING APPARATUS FOR SUPERCONDUCTING CABLES**

(71) Applicant: Supernode Limited, D18 V8P6 Dublin (IE)
(72) Inventor: HODGE, Eoin, Dublin, D07 VX64 (IE); SPOONER, Edward, Bishop Auckland, Durham DL13 2QG (GB)
(74) Representative: FRKelly

(57) **Abstract**

A monitoring apparatus for a superconducting cable comprises magnetic field probes (60) interspersed with conductors (50) that are part of, or connected to, the superconducting cable. A magnetic field sensor (62) is magnetically coupled to each probe (60) and is configured to produce an output signal depending on the sensed magnetic field. The output signals are analysed to determine the condition of the superconducting cable. The magnetic coupling provides electrical isolation against the voltage of the cable core, and thermal isolation between internal cryogenic temperatures and external ambient temperatures.

## Description

### Field of the Invention

The present invention relates to monitoring apparatus and systems for superconducting cables. The invention relates particularly to monitoring apparatus and systems for superconducting power cables.

### Background to the Invention

A superconducting power cable includes a central core comprising many superconducting wires that are commonly referred to as strands or tapes. It is necessary to keep the core temperature at a sufficiently low value to ensure that the superconducting state is maintained, otherwise the tapes become resistive, develop heat through Joule heating leading to rising temperature and a catastrophic runaway situation could arise.

With superconducting wires, the absence of resistance means that current is not necessarily shared equally between the parallel tapes of the cable core. The distribution of current may change as the total current changes. The variation in current distribution is related to the self and mutual inductances of the various tapes and the rates of change of their currents. It would therefore be possible for the current in a tape to exceed the critical current even if the total current is within the critical current of the cable as a whole. Whilst contact resistances and other factors, such as splicing resistances, may cause an uneven current distribution in the tapes or groups of tapes, in operation these tend to be quantifiable, known and fixed system parameters.

It is desirable, especially for long superconducting cables comprising a number of joined lengths, to monitor the current distribution at various positions along the length to determine whether any section contains a failed tape(s) and to identify which length needs to be replaced.

### Summary of the invention

From a first aspect, the invention provides an apparatus for monitoring a plurality of electrical conductors, said conductors being arranged in a plurality of groups, each group comprising at least one conductor, the apparatus comprising: a plurality of magnetic field probes interspersed with said groups of at least one conductor; and a respective magnetic field sensor magnetically coupled to each probe and being configured to produce an output signal that is indicative of at least one aspect of a sensed magnetic field, typically the field strength or changes in field strength, or that is otherwise dependent on the sensed magnetic field.

In some embodiments, each conductor comprises at least one superconducting wire. In other embodiments, each conductor is connectable to at least one respective superconducting wire. The at least one superconducting wire is typically part of a superconducting cable comprising a plurality of superconducting wires.

In typical embodiments, each magnetic field probe comprises at least one bar.

In preferred embodiments, each magnetic field probe comprises first and second parts in an end-to-end arrangement with a gap provided between the first and second parts. The respective magnetic field sensor may be located at an outer end of an outer one of said first and second parts. Preferably, the respective magnetic field sensor is located in said gap.

Preferably, said magnetic field probes are formed from ferromagnetic material that is preferably electrically non-conducting or electrically insulated, and advantageously has a low thermal conductivity.

In preferred embodiments, said magnetic field sensor is a Hall effect sensor. Alternatively, the magnetic field sensor may comprise an inductive magnetic field sensor or a magnetometer.

Preferably, each magnetic field probe is located between respective first and second instances of said groups of at least one conductor.

In preferred embodiments, the apparatus includes a body, said groups of at least one conductor being located within the body, and typically extending from a first end of the body to a second end of the body, and wherein at least part of each magnetic field probe is located within said body between respective first and second instances of said groups of at least one conductor. Preferably, each magnetic field probe comprises a first part located within said body between respective first and second instances of said groups of at least one conductor, and a second part located exteriorly of the body. Preferably, the magnetic field sensor is located exteriorly of the body.

Preferably, the magnetic field sensor is located at an end, preferably an inner end, of the respective second part of the respective magnetic field probe.

Preferably, the body is formed from non-magnetic material. The body is preferably formed from thermally insulating material and/or electrically insulating material, or is otherwise thermally and/or electrically insulated. Typically, said body defines a cavity, said groups of at least one conductor being located in said cavity, and wherein each of said magnetic field probes is at least partially located in said cavity. Optionally, an interior of said body includes a formation, preferably a recessed formation, for receiving a respective first, or interior, part of each probe.

In some embodiments, said groups of at least one conductor are arranged annularly or semi-annularly around a central axis of said body. The groups are preferably symmetrically arranged with respect to said central axis or other axis of the body. The groups are preferably evenly spaced-apart. Each conductor optionally extends parallely or substantially parallely with said axis, or optionally extends helically around said axis.

A respective one of said magnetic field probes, preferably the first, or interior, part of each probe, is located between adjacent groups. Preferably, a respective one of said magnetic field probes is located between all adjacent groups.

In some embodiments, said magnetic field probes are arranged annularly or semi-annularly around the central axis of said conductor housing. The probes are preferably symmetrically arranged with respect to said central axis or other axis of the body. The probes are preferably evenly spaced-apart.

In some embodiments, said magnetic field probes extend radially with respect to said central axis.

Optionally, the exterior of said body includes a formation, preferably a recessed formation, for receiving, preferably removably receiving, the second, or exterior, part of each magnetic probe.

Optionally, said magnetic probes, or at least the respective interior part of the probes, are connected to a common core, each probe preferably extending radially from the core. Said core is preferably located within said body, preferably extending along the central axis of the body. The first, or interior, part of each probe may be connected to the core.

Optionally, the respective second, or exterior, part of said magnetic field probes are provided in at least one probe module, said at least one probe module being located on, or removably locatable on, the exterior of said body, the respective second parts of each probe being arranged in said at least one probe module for alignment with the respective first, or interior, part of the respective magnetic field probe when the probe module is located on the exterior of said body. In some embodiments, said second parts are arranged semi-annularly in the probe module. In alternative embodiments, said second parts are arranged in a linear array in the probe module.

In some embodiments, said groups of at least one conductor are arranged in one or more linear or rectangular array. In some embodiments, said magnetic field probes are arranged in a linear or rectangular array.

Preferably, a respective one of said magnetic field probes, typically the first, or interior, part of each probe, is located between adjacent groups of at least one conductor, preferably between all adjacent groups of at least one conductor.

In preferred embodiments, the apparatus includes, or is in communication with, analysing means for analysing said output signals to determine at least one condition of said conductors and/or of a superconducting cable associated with said conductors.

From a second aspect the invention provides a superconducting cable assembly comprising at least one monitoring apparatus of the first aspect of the invention, said at least one monitoring apparatus being connected to a superconducting cable.

Typically. a plurality of said apparatus are connected to said superconducting cable at respective locations spaced apart along the cable.

Typically, said at least one apparatus is included in a respective joint that connects adjacent sections of the cable.

In some embodiments, each conductor comprises at least one superconducting wire of said superconducting cable. In alternative embodiments, each conductor is connected to at least one superconducting wire of said superconducting cable.

A third aspect of the invention provides a method of monitoring a plurality of electrical conductors using an apparatus according to the first aspect of the invention. The method typically involves analysing the output signals to determine at least one condition of said conductors and/or of a superconducting cable associated with said conductors.

A fourth aspect of the invention provides a superconductor cable monitoring system comprising at least one superconducting cable assembly of the second aspect of the invention and analysing means for analysing said output signals to determine at least one condition of said conductors and/or of a superconducting cable, or superconducting cable section, associated with said conductors.

In preferred embodiments, the monitoring apparatus comprises magnetic field probes interspersed with conductors that are part of, or connected to, the superconducting cable, a respective magnetic field sensor being magnetically coupled to each probe and being configured to produce an output signal depending on the sensed magnetic field. The output signals may be analysed to determine the condition of the superconducting cable. The magnetic coupling provides electrical isolation against the voltage of the cable core, and thermal isolation between internal cryogenic temperatures and external ambient temperatures.

In preferred embodiments, the monitoring apparatus facilitates identification of changes in current carrying performance, indicating a change in conductor performance, in order that such changes may be managed.

In preferred embodiments, magnetic field, or current, probes are used to simultaneously monitor current in multiple current carrying elements of the cable to provide multi-channel current data.

Advantageously, the probes do not contact the superconducting wires or other conductors. The magnetic coupling provides a means of isolation against the very high voltage of the cable core and isolation between cryogenic and normal temperature regions, making the apparatus suitable for use on a sub-sea superconducting cable.

Preferred embodiments of the invention facilitate remote monitoring of the transport current and thereby the condition of individual superconducting wires or tapes or a collection of parallel superconducting wires/tapes that constitute the conductor in a superconducting cable system.

Preferred embodiments allow identification of which tapes or tape groups have quenched and where in the transmission length this has occurred.

Further advantageous aspects of the invention will become apparent to those ordinarily skilled in the art upon review of the following description of specific embodiments and with reference to the accompanying drawings.

### Brief Description of the Drawings

Embodiments of the invention are now described by way of example and with reference to the accompanying drawings in which like numerals are used to denote like parts and in which:
Figure 1 is a block diagram of an electrical power system embodying one aspect of the invention and including a superconducting cable system embodying another aspect of the invention;
Figure 2A is a perspective view of a monitoring apparatus embodying a further aspect of the invention, incorporated into a superconducting cable assembly embodying a further aspect of the invention, the superconducting cable assembly forming part of said superconducting cable system;
Figure 2B is an alternative perspective view of the monitoring apparatus and cable assembly of Figure 2A with the monitoring apparatus shown partly exploded;
Figure 2C is a detail view of a superconducting cable section that is part of the cable assembly of Figures 2A and 2B;
Figure 3 is a sectioned end view of a first embodiment of the monitoring apparatus;
Figure 4 is a sectioned end view of a second embodiment of the monitoring apparatus;
Figure 5 is an illustration of an exemplary magnetic field distribution that may be present during use of monitoring apparatus embodying the invention;
Figure 6 is a graph showing exemplary magnetic field measurements that may be taken by monitoring apparatus embodying the invention;
Figure 7 is a sectioned perspective view of a third embodiment of the monitoring apparatus;
Figure 8 is a sectioned end view of the monitoring apparatus of Figure 7;
Figure 9 is a sectioned end view of a fourth embodiment of the monitoring apparatus; and
Figure 10 is a block diagram of a control system suitable for use with embodiments of the invention.

### Detailed Description of the Drawings

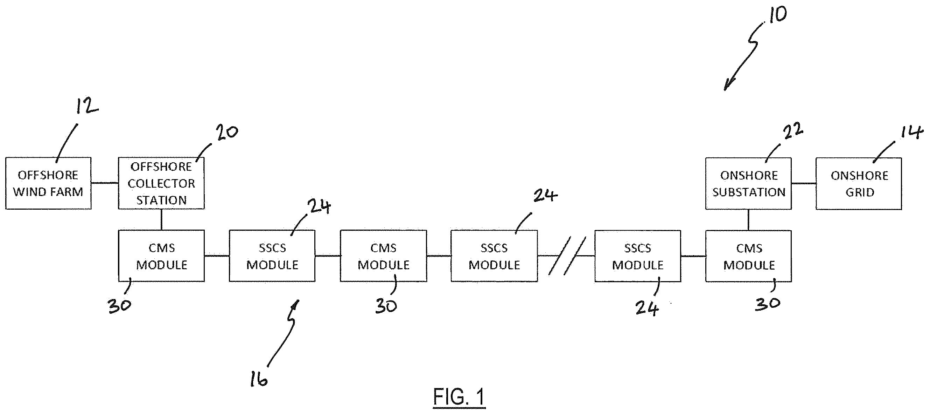

Figure 1 is a block diagram of an electrical power system, generally indicated as 10, embodying one aspect of the invention. The system 10 comprises an electrical power generation system 12 and an electrical power distribution system 14 connected by a superconducting cable system 16 embodying an aspect of the invention. In the illustrated embodiment, the electrical power generation system 12 comprises an offshore wind farm 18 (typically comprising a plurality of wind turbines coupled to electrical generators (not shown)). In alternative embodiments, the electrical power generation system 12 may comprise any other conventional type of electrical power generation system, whether offshore (e.g. a tidal turbine-generator system) or onshore. The system 10 typically includes a power collection system 20 that collects power generated by multiple turbine-generators and provides the collected power to the cable system 16. The collector station 20 typically includes means for converting and transforming the electrical power for transmission by the cable system 16, which may take any conventional form. The electrical power distribution system 14 typically comprises an electrical grid distribution system. The system 10 typically includes a substation 22 for providing electrical power from the cable system 16 to the distribution system 14, and which typically includes convention means for converting and transforming the electrical power as required.

In electrical power systems of the type shown in Figure 1 where the electrical power is generated offshore, it is preferred to transmit DC electrical power to shore. In the illustrated example, AC power generated by the power generation system 12 is converted to DC power at the station 20. As such, in this example the cable system 16 carries DC power. The DC power may be converted to AC power at the substation 22. In alternative embodiments, the superconducting cable system 16 may carry AC electrical power. The voltage level carried by the superconducting cable system 16 may vary depending on the application, for example being in the Low Voltage (LV), Medium Voltage (MV) or High Voltage (HV) ranges, or above.

It will be understood that electrical power systems are just one exemplary application for embodiments of the present invention. Preferred embodiments of the invention may be used in any application for electrical power cables, in particular superconducting power cables.

In typical embodiments, the superconducting cable system 16 comprises a plurality of interconnected superconducting cable modules 24, each cable module 24 comprising a length or section of superconducting cable. The cable modules 24, which are relatively short (e.g. in the order of metres, tens of metres, hundreds of metres or thousands of metres), can be interconnected such that the superconducting cable system 16 is relatively long (e.g. in the order of kilometres, tens of kilometres or longer), and therefore suited to offshore applications. The relatively short cable modules 24 facilitate their storage and transport.

To facilitate remote monitoring of the transport current and thereby the condition of the superconducting cable sections, at least one monitoring apparatus 30 is connected to the cable modules 24. In preferred embodiments, the, or each, monitoring apparatus 30 is connected in-line with the cable modules 24, e.g. to an end of a respective cable module 24, or between the ends of successive cable modules 24. In typical embodiments, there is a plurality of monitoring apparatus 30 spaced apart along the superconducting cable system 16.

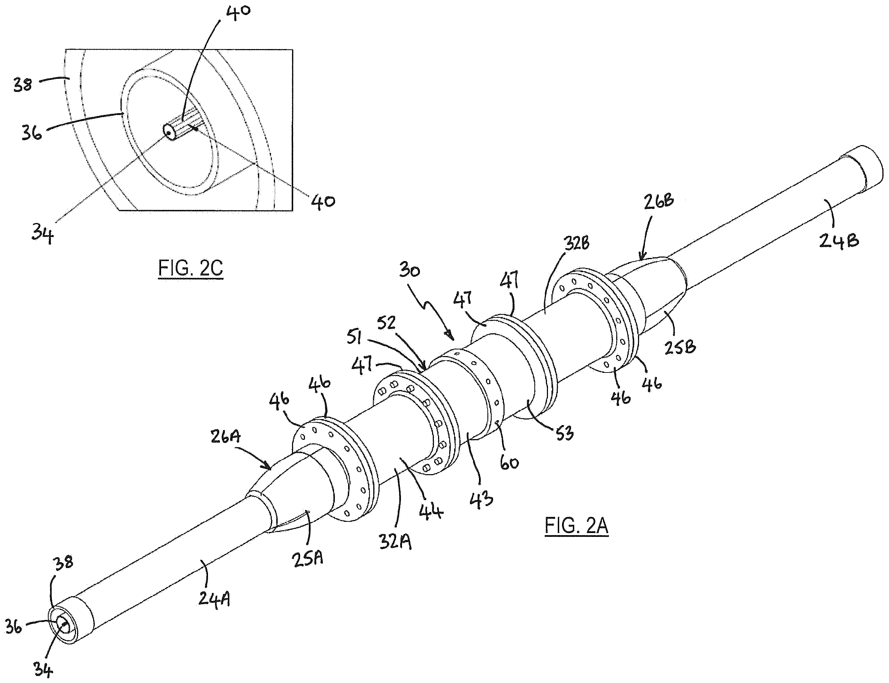

Referring now to Figures 2A to 2C, a preferred embodiment of the monitoring apparatus 30, which embodies an aspect of the invention, is connected in-line between first and second superconducting cable sections 24A, 24B to provide a superconducting cable assembly that embodies another aspect of the invention. The cable sections 24A, 24B, which are embodiments of the cable module 24, are shown as being short to facilitate illustration. In the illustrated embodiment, the monitoring apparatus 30 is connected to an end 25A, 25B of each cable section 24A, 24B by a respective joint 32A, 32B. Alternatively, the monitoring apparatus 30 may be connected directly to the end 25A, 25B of either one or both of the cable sections 24A, 24B.

Each superconducting cable section 24A, 24B comprises a length of superconducting cable, in particular a length of superconducting power cable. The superconducting cable may be of any conventional configuration. Typically, the superconducting cable comprises at least one superconducting conductor 34 located within a cryostat 36, or within a respective cryostat. In the illustrated embodiment, the superconducting conductor 34 and cryostat 36 are provided within an outer casing 38. The cryostat 36 contains cooling fluid (typically liquid nitrogen) for cooling the conductor 34. The exact configuration of the superconducting cable may vary from embodiment to embodiment depending on what type of conventional cable is used. Typically, the cable comprises one or more of the following: electrical insulation, thermal insulation and/or shielding, which may be provided in one or more layers around the conductor (within the cryostat 36 or between the cryostat 36 and the outer casing 38 as applicable). The superconducting cable typically includes at least part of a coolant circuit (not shown) configured to provide a forward path and optionally a return path (e.g. via a respective conduit or cavity) for the cooling fluid. Alternatively, the cooling fluid may be returned through a return pipe (not shown) that is separate from the cable section 24A, 24B, or in a separate superconducting cable, typically of opposite polarity. Optionally, an outer cryostat is provided between the casing 38 and the inner cryostat 36.

In the illustrated embodiment, the superconducting power cable comprises a single superconducting conductor 34. In alternative embodiments (not illustrated), the superconducting power cable may comprise more than one superconducting conductor 34. For example, the cable may be a two-core or coaxial DC superconducting power cable, or a multi-phase AC superconducting power cable with a respective superconducting conductor 34 for each phase.

The superconducting conductor 34 comprises a plurality of superconducting wires 40 (see Figure 2C). The superconducting wires 40 are typically wound around (or otherwise supported by) a core or former, or are otherwise grouped or bundled together to form the conductor 34. The superconducting wires 40 may be formed from any superconducting material. In preferred embodiments the superconducting wires 40 are high-temperature superconductor (HTS) wires, and may be formed from any superconducting material with a high critical temperature (i.e. with high-temperature superconductivity), for example yttrium barium copper oxide (YBCO) or bismuth strontium calcium copper oxide (BSCCO). In preferred embodiments therefore, each superconducting cable section 24A, 24B comprises a length of HTS cable, in particular HTS power cable. Alternatively, the superconducting wires 40 may be low-temperature superconductor (LTS) wires, and may be formed from any superconducting material with a low critical temperature (i.e. with low-temperature superconductivity), for example Nb3Sn (niobium-tin) or NbTi (niobium-titanium). The superconducting wires 40 are typically provided in the form of tapes, i.e. superconducting tapes. The superconducting tape may comprise a tape (e.g. of metal) coated in superconducting material. It is noted that the term "wire" as used herein is intended to embrace "tape" and any other superconducting strand that may be used to form a superconducting power cable.

Each cable section 24A, 24B has a superconducting cable termination 26A, 26B at its end 25A, 25B. Superconducting cable terminations are well known and provide an interface between the superconducting cable and an external component such as a conventional power cable or other device. The cable termination 26A, 26B is configured to unwind, or otherwise separate, the superconducting wires 40 of the, or each, conductor 34. This may be done on a wire-by-wire basis, i.e. such that each wire 40 is separated, or such that the wires 40 are separated into groups, each group containing multiple wires 40. The cable termination 26A, 26B may include a respective external conductive (e.g. copper) terminal (not shown) to which each separated wire 40, or group of wires 40, is connected, and which serve as terminals for connection to the relevant external component. Alternatively, the external terminals can be omitted and the separated wire 40, or group of wires 40, may be connected to a respective terminal provided by the external device. The cable terminations 26A, 26B also include interfacing means, e.g. one or more conduit, for carrying the cooling fluid into and/or out of the cable sections 24A, 24B as required. The cable terminations 26A, 26B are typically also configured to seals the vacuum in the cryotstat(s) of the cable sections 24A, 24B. The cable terminations 26A, 26B may be of any conventional configuration.

In the illustrated embodiment, the respective joint 32A, 32B is connected to the respective cable termination 26A, 26B. Each joint 32A, 32B has a plurality of mutually spaced apart conductors 42. Each conductor 42 may take any suitable form, e.g. a wire, cable, bar, spigot or busbar, preferably being rigid, semi-rigid or otherwise self-supporting, or supported, to allow the conductors 42 to maintain their spaced apart arrangement. The conductors 42 may be formed from any conductive material, for example copper. In preferred embodiments, the conductors 42 are not superconducting. The conductors 42 are located within a housing 44, which may include thermal and/or electrical insulation as required. The housing 44 includes means, e.g. one or more conduit or cavity, for allowing the cooling fluid to pass through the joint 32A, 32B. The conductors 42 extend through the joint 32A, 32B from end-to-end.

The joint 32A, 32B may be mechanically coupled to the respective cable termination 26A, 26B in any conventional manner, e.g. by means of inter-engagable male and female connectors 46. Electrically, each conductor 42 is connected to a respective one of the separated wires 40, or groups of wires 40 at the interface between the joint 32A, 32B and cable termination 26A, 26B. This may be achieved in any convenient manner. For example an end of each conductor 42 may be welded, spliced or otherwise connected to a respective external terminal of the cable termination 26A, 26B, or otherwise to the respective wire 40 or group of wires 40.

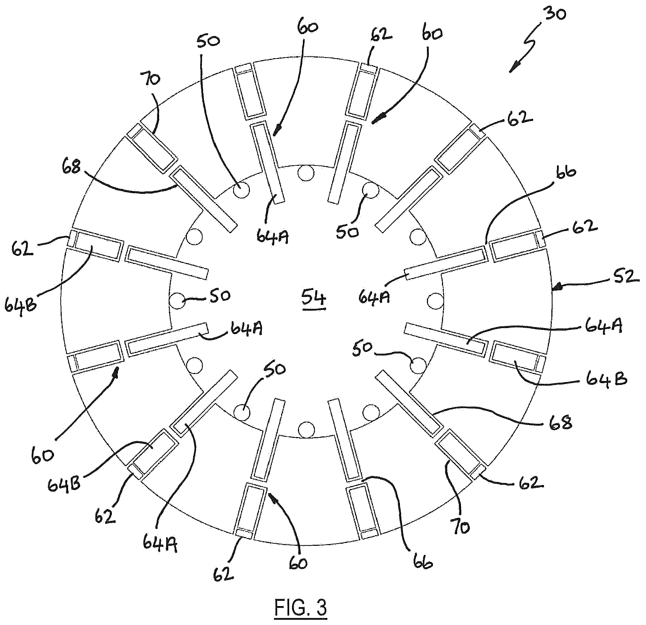

The other end of the joint 32A, 32B is connected to the monitoring apparatus 30. The joint 32A, 32B may be mechanically coupled to the apparatus in any conventional manner, e.g. by means of inter-engagable male and female connectors 47. Electrically, each conductor 42 is connected to a respective conductor 50 of the monitoring apparatus 30 as is described in more detail with reference to Figures 3, 4, 7, 8 and 9. The arrangement is such that the separated wires 40, or groups of wires 40, of the cable termination 26A are electrically connected to a corresponding separated wire 40, or group of wires 40 of the cable termination 26B via the respective conductor 42 of each joint 32A, 32B and the respective conductor 50 of the monitoring apparatus 30. The coolant circuit of each cable section 24A, 24B are connected to each other by the respective coolant interface means, e.g. conduit(s) and/or cavity/ies as applicable, provided by the cable terminations 26A, 26B, joints 32A, 32B and monitoring apparatus 30.

While the joints 32A, 32B facilitate interconnection of cable sections 24A, 24B, and the connection of the monitoring apparatus 30 between cable sections 24A, 24B, they may be omitted. As such the monitoring apparatus 30 may be connected directly between the cable terminations 26A, 26B. The monitoring apparatus 30 may be mechanically coupled to the respective cable termination 26A, 26B in any conventional manner, e.g. by means of any convenient conventional inter-engagable male and female connectors 46, 47. Electrically, each conductor 50 is connected to a respective one of the separated wires 40, or groups of wires 40 at the interface between the monitoring apparatus 30 and cable termination 26A, 26B. This may be achieved in any convenient manner. For example, an end of each conductor 50 may be welded, spliced or otherwise connected to a respective external terminal of the cable termination 26A, 26B or otherwise to the respective wire 40 or group of wires 40. The arrangement is such that the separated wires 40, or groups of wires 40, of the cable termination 26A are electrically connected to a corresponding separated wire 40, or group of wires 40 of the cable termination 26B via the respective conductor 50 of the monitoring apparatus 30. The coolant circuit of each cable section 24A, 24B are connected to each other by the respective coolant interface means, e.g. conduit(s) and/or cavity/ies as applicable, provided by the cable terminations 26A, 26B and monitoring apparatus 30.

Advantageously, the monitoring apparatus 30 is removably interconnectable between the cable sections 24A, 24B (either directly or via the joints 32A, 32B as applicable). These features facilitate installation and removal of the monitoring apparatus 30 in the field. The cable terminations 26A, 26B enable respective cable sections 24A, 24B to be connected directly together in the absence of any intermediate joints 32A, 32B or monitoring apparatus 30.

In alternative embodiments (not illustrated), for example wherein the monitoring apparatus 30 is connected between superconducting cable sections, or incorporated into a superconducting cable, in a permanent or semi-permanent manner, the conductors 50 of the monitoring apparatus 30 may comprise one or more of the superconducting wires 40 of the superconducting cable, or superconducting cable sections, to which the apparatus 30 is connected. For example, each conductor 50 may comprise a separated wire 40, or group of wires 40, of a superconducting cable passing through the monitoring apparatus 30. Optionally, the monitoring apparatus 30 includes a respective support (e.g. a copper bar or other structure) for supporting each wire 40 or group of wires 40 in the apparatus 30. Cable terminations, or other means for separating the wires 40 of the superconducting cable, may be provided at each end of the monitoring apparatus 30 (e.g. as part of a cable section 24A, 24B, or as part of the apparatus 30).

Referring now in particular to Figures 2A to 2C and 3, a preferred embodiment of the monitoring apparatus 30 is described in more detail.

The monitoring apparatus 30 has a body 52, the conductors 50 being located within the body 52. Each conductor 50 may take any suitable form, e.g. a wire, cable, bar, spigot or busbar, preferably being rigid, semi-rigid or otherwise self-supporting, and/or being supported by the body 52, to allow the conductors 50 to maintain a spaced apart arrangement. The body 52 is preferably formed from non-magnetic material, e.g. austenitic stainless steel and/or an epoxy material, such that it does not carry induced magnetic fields in use.

The conductors 50 (which are shown in end cross-section in Figure 3) extend through the body 52 from end 51 to end 53 of the body 52, typically running parallel, or substantially parallel, with each other. Typically, the conductors 50 run parallel or substantially parallel with the longitudinal axis of the body 52, but may be arranged in any convenient manner, e.g. helically. Each end of each conductor 50 is connected, in use, directly or indirectly to a respective wire 40, or group of wires 40, of the respective superconducting cable section 24A, 24B.

The conductors 50 may be formed from any conductive material, for example copper. In preferred embodiments, the conductors 50 are not superconducting, which simplifies the design of the apparatus 50 since the conductors 50 do not need to be maintained at a temperature below a superconducting critical temperature. However, in some embodiments, the conductors 50 may comprise one or more superconducting wires 40, e.g. all or part of an HTS cable or other superconducting cable. For example, each conductor 50 of the monitoring apparatus 30 may be, or may be connected to in use, a respective one the separated wires 40, or respective group of wires 40, of the cable sections 24A, 24B or of a superconducting cable passing through the monitoring apparatus 30. Cable terminations, or other means for separating the wires 40 of the superconducting cable, may be provided at each end of the monitoring apparatus 30 as required.

In cases where the superconducting wires 40 are arranged in groups, it is preferred that there is the same number of wires 40 in each group.

In typical embodiments, the body 52 is shaped to define an interior cavity 54 extending from end 51 to end 53 in which the conductors 50 may be located. The body 52 may be sleeve-like in shape, optionally in the shape of a cylindrical sleeve. The conductors 50 may be fixed to an inner surface of the body 52 (directly or indirectly by any convenient means), or may be embedded in the body 52 (e.g. potted in the body 52 or located in a recess or slot formed in the body). Optionally, the conductors 50 are electrically insulated. Preferably, the body 52 is formed from non-magnetic, electrically insulating, or electrically non-conductive, material, e.g. an epoxy material, or at least a material with low electrical conductivity. The body 52 typically includes an outer casing 43, which is preferably formed from non-magnetic material, e.g. austenitic stainless steel. Structural reinforcement(s) (not shown) may be provided as required, preferably being non-magnetic, e.g. formed from austenitic stainless steel. The material from with the body 52 is formed is preferably thermally insulating, or the body 52 may include thermally insulating material. In preferred embodiments, the body 52 may be, or act as, a cryostat for maintaining the interior of the body 52 at a suitably low temperature as may be required by the embodiment, e.g. to maintain the cavity 54 at or below the relevant critical temperature, or to maintain the cooling fluid passing through the body 52 at its desired temperature. The body 52 provides a solid outer wall and serves as a protective housing for the conductors 50 and other components contained therein. The cavity 54 may contain one or more conduit (not shown), and/or other coolant circuit component(s) or coolant interface means for allowing cryogenic coolant to be passed though the monitoring apparatus 30, e.g. from cable section 24A to cable section 24B in the example of Figure 1 (via the joints 32A, 32B as applicable).

In preferred embodiments, the conductors 50 are arranged in a spaced apart configuration in which each conductor 50 is spaced apart from each other conductor 50. Alternatively, the conductors 50 may be arranged in groups, each group having more than one conductor 50 (preferably the same number of conductors 50), the groups being spaced apart from each other. The conductors 50, or groups of conductors 50, are preferably symmetrically arranged with respect to at least one axis of the body 52, e.g. the central longitudinal axis, and/or a central transverse axis. The spacing between adjacent conductors 50, or groups of conductors 50, is preferably uniform or even.

In some embodiments, including the embodiment of Figure 3, the conductors 50 are spaced apart, preferably uniformly, around the longitudinal axis of the body 52. Preferably, the conductors 50 are arranged annularly around the longitudinal axis, preferably forming a circular ring around the axis.

Alternatively, the conductors 50 may be arranged only partly around the axis, e.g. semi-annularly. It will be understood that instead of individual conductors 50 being spaced apart in this manner (as illustrated), groups of conductors 50 may be spaced-apart in this manner (not illustrated). The configuration of the conductors 50 may depend on the spatial and thermal requirements of the embodiment.

The preferred arrangement of conductors 50 is such that a symmetrical or substantially symmetrical magnetic field is generated around the conductors 50 when normal currents flow in the conductors 50.

The monitoring apparatus 30 further comprises a plurality of magnetic field probes 60, which may alternatively be referred to as current probes, interspersed with the conductors 50. A respective one of the magnetic field probes 60 may be provided between adjacent individual conductors 50 (as illustrated in Figure 3), or between adjacent groups of conductors 50 (not illustrated), depending on how the conductors 50 are arranged.

In preferred embodiments, the probes 60 are formed from ferromagnetic material that is electrically non-conducting or electrically insulated. This helps to prevent short circuits forming between the cable core, which is at a relatively high electrical potential, and the outer casing 43 of the apparatus 30 which is at earth potential. The material preferably has a low thermal conductivity (preferably zero or close to zero). This prevents or reduces the transmission of heat from the external environment to the interior of the body 52. The material preferably has low magnetic hysteresis (preferably zero or close to zero). This helps to avoid distortion of magnetic signals transmitted to the sensors. For example, the probes 60 may be formed from a ferrite material, particularly soft ferrites. Alternatively, the probes 60 may be formed from electrically insulated material, e.g. electrically insulated iron or iron alloy such as magnetic steel.

The preferred magnetic field probes 60 are therefore made of a material with low thermal conductivity and low magnetic hysteresis and which is electrically insulating or electrically insulated to withstand the high voltage near the cable core during use. Soft ferrites are suitable, typically having a thermal conductivity at about 3-4 W/m/K, intermediate between polymers and metals.

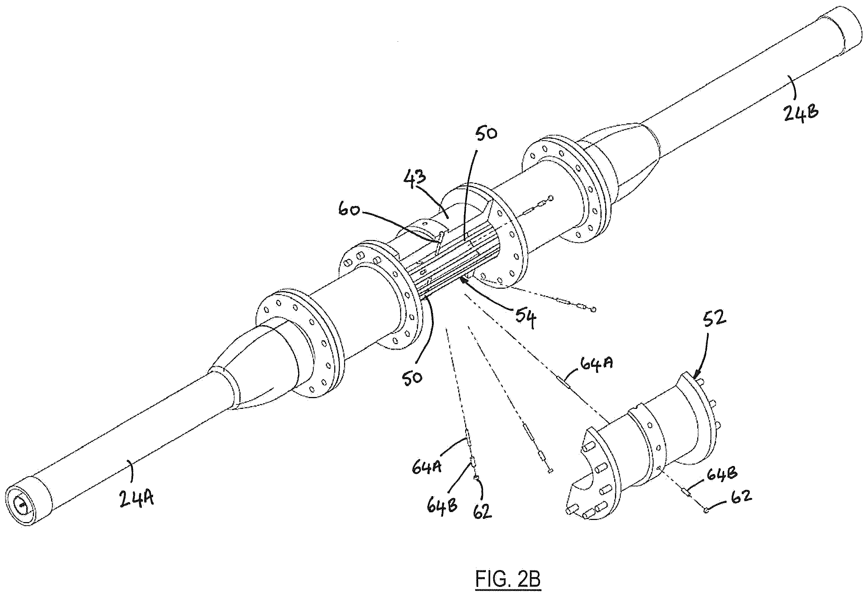

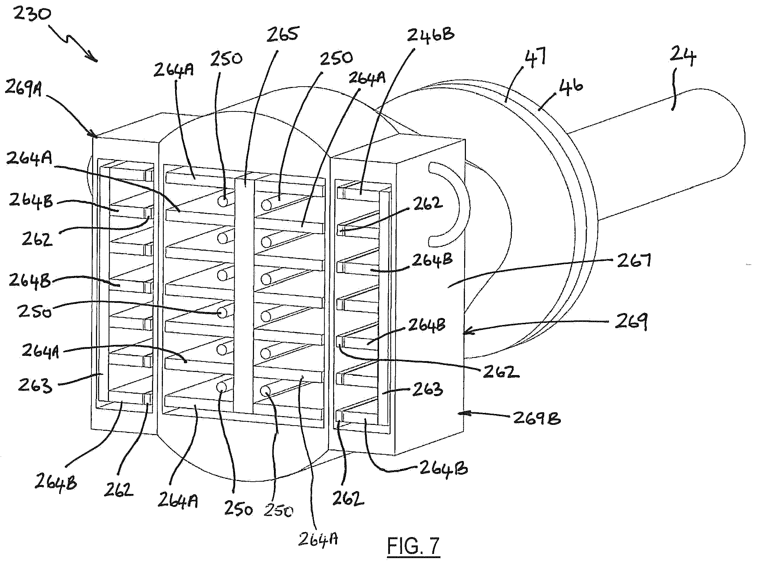

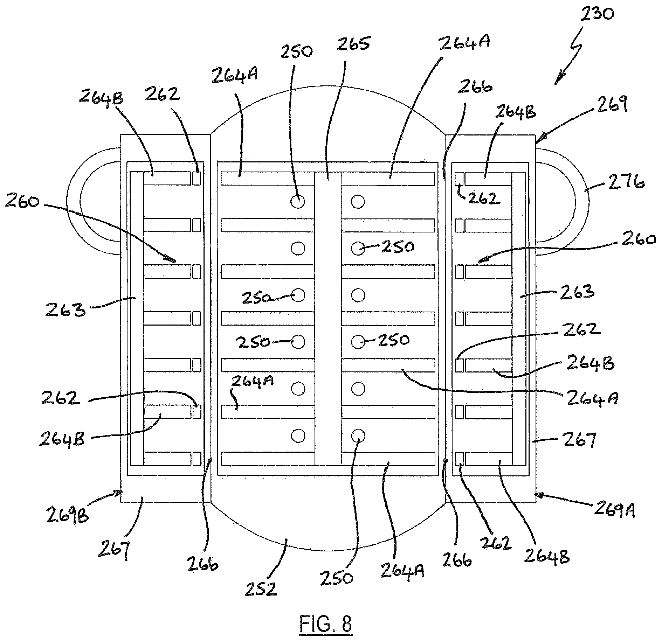

In preferred embodiments, each probe 60 comprises at least one bar 64 or other structure, e.g. a plate. The bar 64 or other structure is preferably straight but may take other shapes. Preferably, each probe 60 comprises first and second separate parts 64A, 64B (first and second bars 64A, 64B in the embodiment of Figures 2 and 3) in an end-to-end arrangement, a gap 66 typically being provided between the adjacent ends of the parts 64A, 64B. The first and second parts 64A, 64B are aligned with each other, preferably such that the probe 60 is straight. Providing the probe 60 as first and second parts is preferred as it facilitates having one part on the inside of the body 52 and the other part on the outside of the body 52. This arrangement is advantageous in that the interior part 64A of the probes 60 are contained within the body 52 (together with the conductors 50), and are advantageously sealed within the body 52, and as such are protected or isolated from the external environment by the body 52. For example, the body 52 may provide any one or more of: structural or mechanical protection, e.g. against the ingress of water; electrical insulation; and/or thermal insulation. In preferred embodiments, the gap 66 is large enough so that the body 52 in the region of the gap 66 provides the requisite protection and/or insulation. However, it is preferred to minimize the size of the gap 66 so as not to adversely affect the operation of the probe 60. Optionally, the respective exterior parts 64B of the probes 60 are connected together to form a magnetic circuit, preferably a closed magnetic circuit (see for example the embodiment of Figures 7 and 8). Creating the magnetic circuit, particularly a closed magnetic circuit, helps to improve the sensitivity of the probes 60/sensors 52, which can close, or at least mitigate the effect of, any magnetic gaps that may otherwise be present, e.g. because of the gaps 66. Providing the probes 60 in first and second parts is also advantageous in that it allows the exteriorly located parts 64B to be accessed for maintenance or replacement.

In some embodiments, including the embodiment of Figure 3, the probes 60, and more particularly the bars 64A, 64B extend radially with respect to the central longitudinal axis of the body 52.

In some embodiments, including the embodiment of Figure 3, the probes 60 are spaced apart, preferably uniformly, around the longitudinal axis of the body 52. Preferably, the probes 60 are arranged annularly around the longitudinal axis, preferably forming a circular ring around the axis. Alternatively, the probes 60 may be arranged only partly around the axis, e.g. semi-annularly. The probes 60 are preferably arranged symmetrically around the body 52, e.g. with respect to a central axis of the body 52. A symmetrical arrangement has the advantage of eliminating the effect of interfering flux driven by the bulk current in the cable core. It will be understood however that a symmetrical arrangement of probes 60, or more generally a symmetrical magnetic field around the conductors 50, is not essential to the invention.

A respective magnetic field sensor 62 is magnetically coupled to each probe 60, and is configured to produce an output signal that is indicative of at least one aspect of a sensed magnetic field, typically the magnetic field strength and/or changes in the magnetic field strength. In preferred embodiments the magnetic field sensor 62 is a Hall effect sensor, in particular a linear Hall effect sensor, although any other conventional magnetic field sensor may be used. For example, the magnetic field sensor 62 may be an inductive magnetic field sensor, for example comprising one or more inductive coil, or any conventional magnetometer. Inductive magnetic field sensors (which detect changes in magnetic field) are particularly suited to embodiments in which the cable being monitored carries AC electrical power, although they may also be used when the cable carries DC power since some detectable cable events, for example a fault or quench, cause transient changes in the magnetic field, and since in applications where the power is being generated by a renewable energy source, e.g. wind, the generated power may fluctuate. In preferred embodiments, in particular where the sensor 62 is a Hall effect sensor, the sensor 62 is configured to measure the magnitude of a magnetic field, its output signal being directly proportional to the magnetic field strength through it. Each magnetic field sensor 62 may be connected to or coupled to the respective magnetic probe 60 directly or indirectly in any convenient manner, e.g. using any suitable fixing means, e.g. bonding, or located around the probe (for example in the case where the sensor comprises one or more coil).

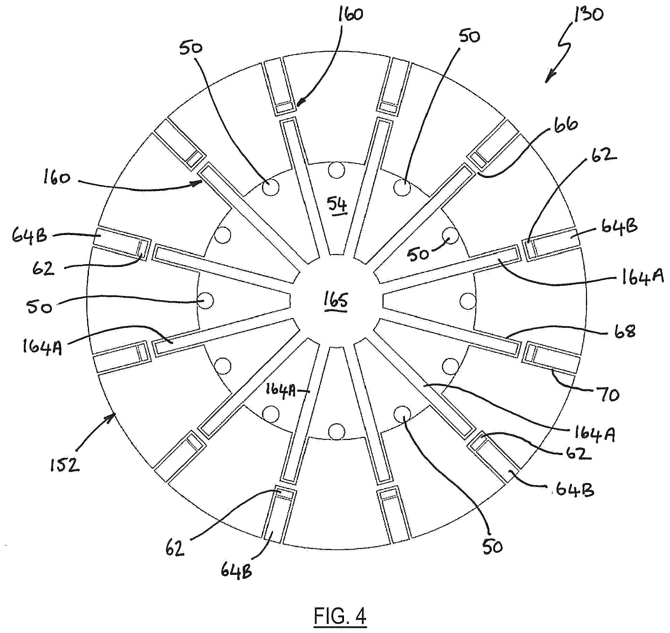

The magnetic field sensor 62 may be located an end of the respective probe 60, preferably an outer end as illustrated in Figure 3. Alternatively, the magnetic field sensor 62 may be located at location intermediate the ends of the probe 60 (which is preferred as this protects the sensor most from environmental fields and makes its reading more sensitive), for example in the gap 66 (as illustrated in the embodiment of Figure 4), or at either end of either one of the probe parts 64A, 64B, in particular the inner end of the outer part 64B (as illustrated in Figure 4). The first and second parts 64A, 64B may have, but do not necessarily have, a uniform cross section. Advantageously, probe 60 is tapered to gather a relatively large magnetic flux from the region of the conductors 50 and concentrate it at the gap 66 where the magnetic field sensor may be located.

In preferred embodiments, each magnetic field probe 60 comprises an interior part (which in the embodiment of Figure 3 comprises the first (or interior) bar 64A) that is located within the body 52, and a separate exterior part (which in the embodiment of Figure 3 is provided by the second (or exterior) bar 64B) that is located on the outside of the body 52. The interior and exterior parts 64A, 64B may be, but do not have to be, formed from the same material. Preferably, the respective magnetic field sensor 62 is located at the outer end of the exterior part 64B (e.g. as illustrated in Figure 3), or at the inner end of the exterior part 64B. Locating the magnetic field sensor 62 and part 64B of the probe 60 exteriorly of the body 52 is advantageous as it facilitates operator access, e.g. for maintenance, installation or replacement.

In preferred embodiments, the respective interior part 64A of each magnetic field probe 60 is at least partially located in the cavity 54.

In preferred embodiments, the magnetic field probes 60 are supported by the body 52, for example being potted or embedded in the body 52 or located in a recess or other formation. In some embodiments, including the embodiment of Figure 3, the interior of the body 52 includes a respective formation 68, preferably a recessed formation, e.g. a slot, for receiving the respective interior part 64A of each probe 60. The formation 68 may be preformed or formed during an embedding or potting process. In some embodiments, including the embodiment of Figure 3, the exterior of the body 52 includes a respective formation 70, preferably a recessed formation, e.g. a slot, for receiving the respective exterior part 64B of each probe 60, and preferably also the respective magnetic field sensor 62. The formation 70 may be preformed or formed during an embedding or potting process. It is preferred that the magnetic field sensor 62, and preferably also the exterior probe part 64B are removable, e.g. to facilitate maintenance or replacement. The gap 66 is defined between the respective formations 68, 70. In alternative embodiments, the exterior part 64B of each probe 60 may be provided exteriorly of the body 52 in other ways, e.g. on or in an outside of the body 52, as illustrated in Figures 7 to 9 described hereinafter.

In preferred embodiments, the arrangement is such that a respective one of the interior probe parts 64A is located between adjacent conductors 50, or between adjacent groups of conductors 50, preferably between all adjacent conductors 50 or groups of conductors 50. The preferred arrangement is such that the respective probe 60, in particular the respective interior probe part 64A, extends between the respective adjacent conductors 50, or between adjacent groups of conductors 50, so as to separate them from each other. In particular, it is preferred that each conductor 50, or group of conductors 50, is located in a gap defined between respective adjacent probes 60. Preferably, the probes 60 extend to the centre of the cavity 54, for example to a common core 165 as illustrated in Figure 4. Alternatively, the probes 60 do not project into the cavity and are instead contained within the body 52. This is not a preferred arrangement as it may adversely affect the sensitivity of the apparatus 30 although this problem can be mitigated by providing the exterior probe parts 64B in a closed magnetic circuit.

Figure 3 shows 12 conductors 50 and 12 magnetic field probes 60 by way of example. Other embodiments may have more or fewer conductors and probes.

Figure 4 shows an alternative embodiment of the monitoring apparatus 130, which is similar to the monitoring apparatus 30 of Figure 3 and in respect of which like numerals denote like parts and the same or similar description applies unless otherwise stated, and as would be apparent to a skilled person. In this embodiment, the interior part 164A of each magnetic field probe 160 is connected to a common core 165, preferably such that the interior probe parts 164A extending radially from the core 165. The core 165 is preferably formed from ferromagnetic material and may conveniently be formed from the same material as the probes 60. However, the core 165 does not need to be electrically or thermally non-conducting since it does not come into contact with the outer casing 43. Conveniently, the interior probe parts 164A are integrally formed with the core 165. The core 165 is located within the body 152 (in cavity 154 in the example of Figure 4), and preferably extends along the central longitudinal axis of the body 152.

In use, electrical current flows through the conductors 50 generating a corresponding magnetic field around the conductors 50. The magnetic field probes 60, 160 are located in the magnetic field and deliver a measurable magnetic signal to the respective sensor 62. In particular, each probe 60 has the effect of concentrating and directing the local magnetic field such that a measurable magnetic field is provided at the respective sensor 62. The respective magnetic field sensor 62 of each probe 60, 160 generates an output signal depending on the strength of the magnetic field at the respective location of the probe 60, 160 and sensor 62 (and/or depending on changes in magnetic field strength). The magnetic field distribution around the conductors 50, including the magnetic field strength at any given location, is determined by the respective current flowing through the conductors 50. The output signal of each magnetic field sensor 62 therefore provides an indication of the current, or current level, flowing in either one of, or each of, the conductors 50, or groups of conductors 50, between which it is located. The output signals of the magnetic field sensors 62 may therefore be used to monitor the current flowing in the conductors 50. As such, the magnetic field probes 60, 160 may be referred to as current probes. In particular, the output signals of the magnetic field sensors 62 may be used to monitor the distribution of currents in the conductors 50, e.g. to detect uneven current distribution, changes in current distribution and/or other anomalies in current distribution. The detected current distribution amongst the conductors 50 provides an indication of the condition of the wires 40, or groups of wires 40, of the superconducting cable sections 24A, 24B to which the monitoring apparatus 30 is connected, or of the superconducting cable into which the monitoring apparatus 30 is incorporated, as applicable.

In alternative embodiments (not illustrated), the exterior part 64B of any one or more of the probes 60 may be omitted. As such, the probe 60 may be located internally of the body 52 only. The respective magnetic field sensor 62 may still be located exteriorly of the body 52, for example in the respective formation 70 (preferably at the bottom of the formation 70), such that the respective interior probe 60 may direct the magnetic field to it. Providing the probe 60 with an exterior part is nevertheless preferred as it causes the magnetic field to be drawn to the exterior of the body 52 for better detection by the sensor 62, particularly in embodiments where the sensor 62 is located in the gap 66 since the exterior part of the probe 60 causes the magnetic field to be drawn through the sensor 62.

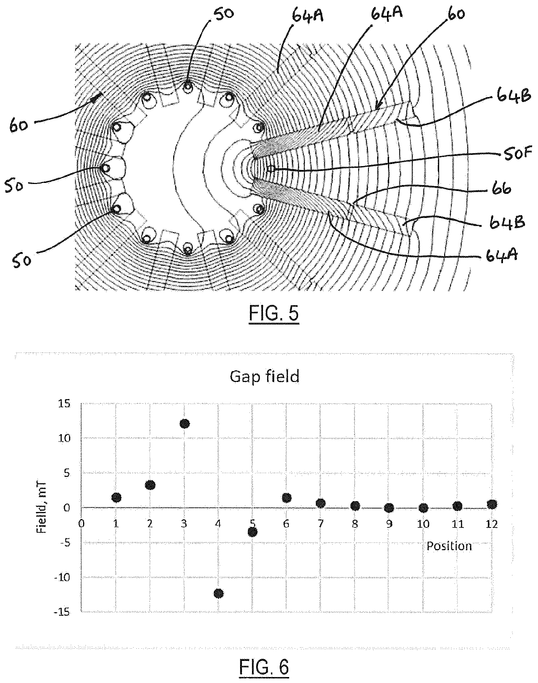

By way of example, Figure 5 shows an exemplary magnetic field distribution around the conductors 50. In this example it is assumed that there is a fault in conductor 50F, or that it has been quenched, resulting in an anomaly in the magnetic field distribution in the vicinity of the conductor 50F. Otherwise, the magnetic field distribution around the conductors is substantially symmetrical, which is a result of the preferred symmetrical arrangement of the conductors 50 together with substantially equal or normal currents flowing in all of the conductors except conductor 50F. The anomaly in the magnetic field around conductor 50F causes a corresponding anomaly in the output of the magnetic field sensors 62 of the probes 60 beside conductor 50F. The outputs of the other magnetic field sensors 62 are substantially the same in this example as a result of the symmetrical magnetic field in the vicinity of the respective probes 60.

Figure 6 illustrates the corresponding outputs of each of the magnetic field sensors 62, where the outputs at position 3 and 4 relate to the sensors 62 of the probes 60 located on either side of the conductor 50F. The absence of current in conductor 50F between probes 60 at positions 3 and 4 is indicated by a reversal of magnetic field being detected at positions 3 and 4. Figure 6 shows that the sensor 62 at position 3 detects a relatively high positive magnetic field, while the sensor 62 at position 4 detects a relatively high negative magnetic field. These sensor outputs at positions 3 and 4 allow the magnetic field anomaly around conductor 50F to be detected, and so allow a corresponding determination to be made in relation to the current flowing in conductor 50F, i.e. that there is no current in this example.

In some embodiments, including those of Figures 3 to 5, the configuration may be such that each conductor 50 carries the same current in normal conditions. As such the radial magnetic field in the probes 60 is zero or substantially zero. As illustrated above in Figures 5 and 6, this arrangement is particularly well suited for detecting current anomalies caused by, e.g. a fault or quenching, within individual conductors 50.

The simple pattern of signals shown in Figure 6 corresponds to scenario in which a single conductor 50F carrying zero current while the other conductors 50 carry the same current. In practice more complicated situations may arise in which more than one conductors 50 carries only part of its share of the current, or where conductors 50 being or corresponding to wires 40 in different layers of the superconducting cable carry different current because of long-lasting mutual inductive coupling between layers, or different contact or splicing resistances, and so on, as applicable. Accordingly, distinguishing faults from innocuous conditions may be complex.

An analyser 80 is provided for analysing the output signals of the magnetic field sensors 62. The analyser may be configured to determine a respective current level for each conductor 50, and/or to analyse the respective measured current levels, and/or to make determinations relating to the condition of the wires 40, or groups of wires 40, and/or of the superconducting cable, as desired, based on its analysis of the output signals. The analyser 80 may take any convenient form, for example comprising one or more suitably programmed processor (e.g. computer or microcontroller) and/or signal processing circuit(s). The analyser 80 may be provided with or have access to cable condition reference data, e.g. a look-up table, and be configured to compare measured output signals against the reference data in order to make determinations relating to cable condition. The analyser may be configured to use machine learning or other Artificial Intelligence (AI) technique to analyse the outputs of the magnetic field sensors 62 in order to determine the condition of or relating to the conductors 50 and/or of the associated superconducting cable as applicable (including detecting faults or other problematic conditions). The analyser 80 may take any conventional form, and may use supervised or unsupervised machine learning, and be trained as required, using any suitable conventional Al techniques. The analyser 80 may be trained or otherwise configured to recognise one or more normal conditions for the conductors 50, and to detect one or more abnormal conditions, as applicable to the embodiment. The analyser 80 may analyse the probe outputs, preferably in real time, and convert these to current levels (which are representative of conductor condition), preferably in real time.

Typically, the current flowing through the cable system 16 is variable since the current produced by the power generation system 12 is variable. Accordingly, the magnetic field strength measured by the magnetic field sensors 62 varies correspondingly. The analyser 80 may therefore be configured to account for such variations in sensor output when determining the condition of the cable. This may be achieved using machine learning as described above.

The output signal of the magnetic field sensor 62 of each probe 60 may be affected by engineering tolerances relating to the apparatus 30. Accordingly, calibration of the output signals is preferably performed, typically at the time of commissioning.

In embodiments where each conductor 50 is, or is connected to, a respective superconducting wire 40, and in which each conductor 50 is located between respective magnetic field probes 60, the current in each wire 40, and therefore the condition of each wire 40, can be monitored individually. In other embodiments, for example in which each conductor 50 comprises, or is connected to, a respective group of wires 40, and/or wherein each conductor 50 is not located between its own respective probes 60, the current in each wire 40 and therefore the condition of each wire 40 cannot be monitored individually. By way of example, in some embodiments, each conductor 50 may be a spigot or the like, a respective group of wires 40 being connected (directly or indirectly) in parallel through the respective conductor 50. This configuration is disadvantageous in that it does not provide enough resolution to determine which wire 40 of the respective group might be faulty, but is advantageous in that the arrangement of the conductors 50 and probes 60 is simpler.

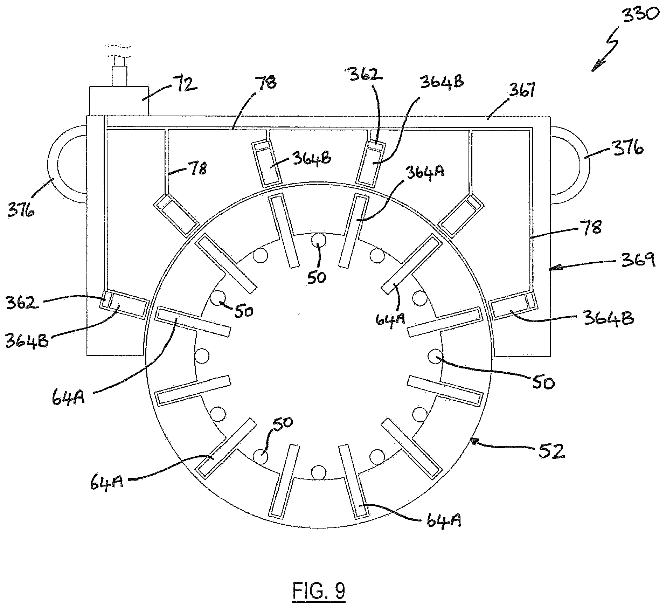

The monitoring apparatus 30 typically includes a control unit 72, which may be provided in a module mounted on the body 52 (as illustrated in Figure 9 by way of example), or included in the body 52, as is convenient.

The control unit 72 receives the outputs from each of the sensors 62. The control unit 72 typically includes a sensor output processor 76, typically comprising electronic signal processing circuitry for processing (e.g. amplifying and/or otherwise conditioning as required) the output signals of the magnetic field sensors 62, and which typically produces an output value for each sensor 62. In typical embodiments, the output value is indicative of the current level in the respective conductor(s) 50.

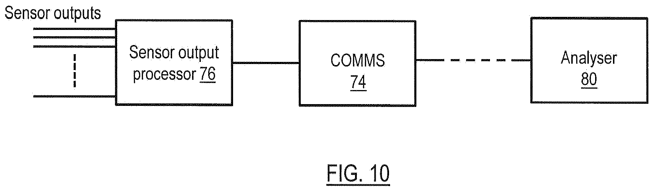

The control unit 72 may comprise the analyser 80 for analysing the output from the magnetic field sensors 62 and making corresponding determination(s) in relation to the condition of the superconducting cable or cable sections with which the apparatus 30 is associated. Alternatively, the analyser 80 may be located remotely of the apparatus 30, for example at an onshore or otherwise remote monitoring station (not shown). In either case, the sensor output processor 76 may provide its output to the analyser 80 directly or indirectly for this purpose. Figure 10 shows the control unit 72 as part of a control system of which the control unit 72 is located at the monitoring apparatus 30 and the analyser 80 is located remotely from the monitoring apparatus 30. The control unit 72 may include one more conventional communication module 74 for supporting wired or wireless communication with the analyser 80 or otherwise with the remote monitoring station.

The control unit 72 may include one or more electrical power source (not shown), for example one or more battery, and/or may be connected to one or more electrical power source.

As can be seen from Figure 1, a plurality of instances of the monitoring apparatus 30 may be spaced apart along the length of the superconducting cable system 16, each instance monitoring the cable current and/or cable condition at the their respective location. The outputs from each instance of the monitoring apparatus 30 may be communication to the remote monitoring station. Optionally, each instance of the monitoring apparatus 30 communicates with the same analyser 80 (located at the remote monitoring station). Alternatively each instance of the apparatus 30 may have its own analyser 80.

Options for supplying power to the monitoring apparatus 30 include: optical power transmitted by one ore more optical fibre provided along the cable system 16 and connected to the control system 72 and/or other electronic component(s) as applicable; one or more battery with sufficient capacity to operate for a period between scheduled maintenance operations; one or more solar panels (not shown) provided on the outside of the apparatus 30, e.g. for locations where the cable system 16 is exposed to light either on land or in shallow water. It is also possible to power the apparatus 30 from the cable system 16, either by direct connection or inductively.

Transmitting data (which may comprise the magnetic field sensor output signals and/or the output of the analyser as applicable) to a monitoring station may be accomplished by any conventional manner, for example: a fibre optic communication link embedded in or otherwise provided on the cable system 16 and connected to the control system 72; a radio transmitter or transceiver, especially if the cable system 16 is exposed on land or via an antenna on a tethered buoy or the like if the cable system 16 is located in water of moderate depth.

Signals may be transmitted to the monitoring station in relatively short bursts with relatively long dormant periods between, although alarms may be transmitted also be sent if the currents approach a dangerous level. The typical average power requirement for data transmission is small so that the power supply system can be simple.

The circular arrangement of conductors 50 and probes 60, for example as illustrated in Figures 3 and 4, is preferred because it is insensitive to the overall field of the total cable current. However, other arrangements of conductors 50 and/or probes 60 are possible.

For example, Figures 7 and 8 show an alternative embodiment of the monitoring apparatus 230, which is similar to the monitoring apparatus of Figures 3 and 4, and in respect of which like numerals denote like parts and the same or similar description applies unless otherwise stated, and as would be apparent to a skilled person. In this embodiment, the conductors 250 are arranged in a linear manner rather than a circular manner. In particular, the conductors 250 are arranged in a rectangular array or a linear array. The illustrated array has two columns and six rows, although the number of rows and columns may vary from embodiment to embodiment. Preferably, the array has one column or two columns (and any number of rows), or one row or two rows (and any number of columns). The respective interior part 264A of each magnetic field probe 260 are located between respective adjacent conductors 250 within the body 252. The interior parts 264A, which may be plate-like or bar-like in shape, may be arranged in a linear or rectangular array corresponding to the array in which the conductors 250 are arranged. Optionally, the interior parts 264A are connected to a common core 265 located within the body 252, which may be plate-like or bar-like in shape. The core 265 may be located between the two columns of conductors (in the case where there are only two columns), or between the two rows (in the case where there are only two rows).

The exterior part 264B of each probe 260 is aligned with the corresponding interior part 264A and located outside of the body 252. The exterior parts 246B may be provided in a probe housing 267 as part of a probe module 269, which may be mounted on the outside of the body 252. Optionally, the probe module 269 is removably mountable on the body 252, which facilitates maintenance. The probe module 269 may be mounted on the body 252 using any convenient coupling or fixing means (not shown), for example bolts, clips or magnetic coupling(s). The probe housing 267 holds the exterior parts 264B in an arrangement that causes them to be in alignment with the respective interior part 264A when the module 269 is fitted to the body 252. Optionally, first and second probe modules 269A, 269B are provided, and are mounted on or mountable on a respective side of the body 252. Alternatively, there may be only one probe module 269.

The respective magnetic field sensor 262 is preferably provided in the probe module 269, preferably at or on an end of the respective exterior part 264B. The preferred arrangement is such that the magnetic field sensors 262 are located in the respective gap 266 when the probe module 269 is mounted on the body 252. Preferably, the exterior parts 264B are interconnected to form a magnetic circuit. This may be achieved by interconnecting the exterior parts 264B using one or more ferromagnetic structure 263, e.g. bar(s), plate(s) or the like. In the illustrated embodiment, the exterior parts 264B are connected together at their outer ends.

Conveniently, the body 252 is shaped to have a flat surface on which the, or each, probe module 269 can be mounted, the probe housing 267 preferably having a corresponding flat surface for engaging with the respective flat surface of the body 252. For example, either one or both of the body 252 and the probe housing 267 may be rectangular in transverse and/or longitudinal cross section.

In some applications, access for maintenance, repair or replacement of magnetic field sensors may be more difficult from one side of the cable than another, or from beneath the cable. In such cases, there may be a probe module 269 on one side of the body 252 only, i.e. the accessible side. In such cases, it is preferred for the conductors 250 to be arranged in a single row or column.

Figure 9 shows a further alternative embodiment of the monitoring apparatus 330, which is similar to the monitoring apparatus of Figures 3, 4, 7 and 8, and in respect of which like numerals denote like parts and the same or similar description applies unless otherwise stated, and as would be apparent to a skilled person. In this embodiment, the body 52, and the arrangement of probes 60 and conductors 50, may the same as for the apparatus 30 of Figure 3 (and so the same reference numerals are used). However, this embodiment is similar to the embodiment of Figures 7 and 8 in that the exterior parts 364B of the probes 360 are located in a probe housing 367 as part of a probe module 369 that is mounted on, or removably mountable on, on the outside of the body 52. The exterior parts 346B may be provided in a semi-annular or arc-like arrangement in the housing 367 that is configured to match the annular arrangement of the corresponding interior parts 64A of the respective probe 360 so that the respective interior and exterior parts 64A, 364B are aligned when the module 369 is fitted to the body 52. Preferably, the probe housing 367 as a concave surface for engaging with the correspondingly convex exterior surface of the body 52. In the illustrated embodiment, the module 369 includes a respective exterior part 364B for half of the interior parts 64 provided in the body 52. Alternatively, the module 369 includes a respective exterior part 364B for more than or fewer than half of the interior parts 64 provided in the body 52.

Optionally, one or more additional probe modules (not shown), with respective exterior probe part(s), may be provided and may be the same or similar to the module 369, and may be displaced (typically circumferentially and/or longitudinally displaced) with respect to the module 369 so that its exterior probe parts align with one or more other interior probe parts 64A. For example, with reference to Figure 9, a second probe module may be mounted on the opposite side of the body 52 to the illustrated module 369 (i.e. circumferentially displaced by 180°) and aligned with the interior probe parts 64 at the opposite side of the body 52.

Optionally, the conductors 50 may be arranged to extend helically through the body 52 from end 51 to end 53 such that, at at least one location along the length of the body 52, each conductor 50, or group of conductors 50, is located at the top of the housing. One or more additional probe module (not shown) with respective exterior probe part(s), may be provided and may be the same or similar to the module 369. The additional probe module may be located on the same side of the body 52 as the module 369 but displaced in the longitudinal direction of the body 52 such that its exterior probe parts align with one or more corresponding interior probe parts (not shown) that are correspondingly displaced along the body from the interior probe parts 64 that align with the first probe module 369, and which are located between conductors 50 or groups of conductors 50 that are different from those located between the interior probe parts 64A that are aligned with the first module 369 (because of the helical arrangement of the conductors 50). In particular, the additional probe module may be spaced apart from the first module 369 by a distance corresponding to half of the helical pitch of the conductors 50. This arrangement allows the current in all of the conductors or groups of conductors to be monitored.

Any convenient corresponding locating features (not shown) may be provided on the housing 267, 367 and the body 352, 52 for aligning the housing 267, 367 on the body 352, 52. Any convenient retaining means (not shown) may be provided on the housing 267, 367 and the body 352, 52 for retaining, preferably releasably, the housing 267, 367 on the body 352, 52. Optionally, one or more lifting formation 276, 376 may be provided on the probe housing 267, 367 to facilitate its fitting and removal.

Optionally, the control system 72 may be mounted on the housing 267, 367. Figure 9 shows electrical connections 78 for delivering the output signals of the magnetic field sensors 362 to the control system 72.

Preferred embodiments provide a distributed cable monitoring system having elements located at discrete locations along the transmission cable length, delivering non-contact current monitoring of the superconducting cable using magnetic coupling. The magnetic field probes deliver measurable magnetic signals to the magnetically coupled external sensor system.

The invention is not limited to the embodiment(s) described herein but can be amended or modified without departing from the scope of the present invention.

## Claims

1. An apparatus for monitoring a plurality of electrical conductors, said conductors being arranged in a plurality of groups, each group comprising at least one conductor, the apparatus comprising:
a plurality of magnetic field probes interspersed with said groups of at least one conductor; and
a respective magnetic field sensor magnetically coupled to each probe and being configured to produce an output signal that is indicative of at least one aspect of a sensed magnetic field.

2. The apparatus of claim 1, wherein each conductor comprises at least one superconducting wire, or is connectable to at least one respective superconducting wire, said at least one superconducting wire typically being part of a superconducting cable comprising a plurality of superconducting wires.

3. The apparatus of claim 1 or 2, wherein each magnetic field probe comprises first and second parts in an end-to-end arrangement with a gap provided between the first and second parts, and wherein, preferably, the respective magnetic field sensor is located at an outer or inner end of an outer one of said first and second parts, or in said gap.

4. The apparatus of any preceding claim, further comprising a body, said groups of at least one conductor being located within the body, typically extending from a first end of the body to a second end of the body, and wherein at least part of each magnetic field probe is located within said body between respective first and second instances of said groups of at least one conductor.

5. The apparatus of claim 4, wherein each magnetic field probe comprises a first part located within said body between respective first and second instances of said groups of at least one conductor, and a second part located exteriorly of the body.

6. The apparatus of claim 4 or 5, wherein each magnetic field sensor is located exteriorly of the body, preferably being located at an end, preferably an inner end, of an exterior part of the respective magnetic field probe.

7. The apparatus of any one of claims 4 to 6, wherein said body defines a cavity, said groups of at least one conductor being located in said cavity, and wherein each of said magnetic field probes is at least partially located in said cavity.

8. The apparatus of any preceding claim, wherein said groups of at least one conductor are arranged annularly or semi-annularly or in a linear array or in a rectangular array, and wherein said magnetic field probes are correspondingly arranged annularly or semi-annularly or in a linear array or in a rectangular array.

9. The apparatus of any preceding claim, wherein a respective one of said magnetic field probes is located between at least some, preferably all, adjacent groups of said at least one conductor.

10. The apparatus of any one of claims 4 to 7, wherein said magnetic field probes extend radially or laterally with respect to a central axis of the body.

11. The apparatus of any preceding claim, wherein said magnetic field probes are connected to a common core, each magnetic field probe preferably extending radially or laterally from the core.

12. The apparatus of claim 5, wherein the respective second part of said magnetic field probes are provided in at least one probe module, said at least one probe module being located on, or removably locatable on, the exterior of said body, the respective second parts of each probe being arranged in said at least one probe module for alignment with the respective first part of the respective magnetic field probe when the probe module is located on the exterior of said body.

13. The apparatus of any preceding claim, including, or being in communication with, analysing means for analysing said output signals to determine at least one condition of said conductors and/or of a superconducting cable associated with said conductors.

14. A superconducting cable assembly comprising at least one monitoring apparatus as claimed in any preceding claim, said at least one monitoring apparatus being connected to a superconducting cable, and wherein, optionally, a plurality of said apparatus are connected to said superconducting cable at respective locations spaced apart along the cable, and wherein, optionally, said at least one apparatus is included in a respective joint that connects adjacent sections of the cable.

15. The cable assembly as claimed in claim 14, wherein each conductor comprises at least one superconducting wire of said superconducting cable, or is connected to at least one superconducting wire of said superconducting cable.
